Europäisches Patentamt

European Patent Office

Office européen des brevets

(19)

(11) Publication number: **0 404 405**

**A2**

(12) **EUROPEAN PATENT APPLICATION**

(21) Application number: **90306272.7**

(22) Date of filing: **08.06.90**

(51) Int. Cl.5: **H01L 39/22**

(30) Priority: **20.06.89 GB 8914167**

(43) Date of publication of application:
**27.12.90 Bulletin 90/52**

(84) Designated Contracting States:
**AT BE CH DE ES FR GB IT LI LU NL SE**

(71) Applicant: **IMPERIAL CHEMICAL INDUSTRIES PLC**
**Imperial Chemical House, Millbank**
**London SW1P 3JF(GB)**

(72) Inventor: **Gough, Colin Edward**
**44 School Road**
**Moseley, Birmingham B13 9SN(GB)**
Inventor: **Keene, Mark Nicholas**
**7 Poole Crescent**
**Harborne, Birmingham B17 0PE(GB)**

(74) Representative: **Walmsley, David Arthur**
**Gregson et al**
**Imperial Chemical Industries PLC Legal**
**department: Patents PO Box 6 Bessemer**
**Road**
**Welwyn Garden City Hertfordshire AL7**
**1HD(GB)**

(54) **Superconducting device.**

(57) A device which comprises a superconductor having a low critical temperature which may be 20K or below in contact with a superconductor having a high critical temperature which may be 77K or above. The superconductors may respectively be of the metal or alloy type and of the ceramic oxide type, and the device may be a SQUID.

EP 0 404 405 A2

## SUPERCONDUCTING DEVICE

This invention relates to a superconducting device, that is a device which is capable of conducting an electrical current at zero resistance.

Superconducting materials have been known for many years and stem from the initial discovery that the resistance to the passage of an electrical current in mercury became immeasurably small when the mercury was cooled to a temperature of about 4K.

Subsequently many other metals and alloys were shown to possess this property of superconductivity, and metals and alloys commonly used in the production of superconducting devices include niobium and alloys of niobium, eg niobium-tin and niobium-titanium alloys. Other alloys which are known to be superconducting include alloys of two or more metals none of which is individually superconducting, and an example of such an alloy is a bismuth-lead alloy.

All of these known superconducting metals or alloys have one characteristic in common which is that the critical temperature, that is the temperature at which the transition to the superconducting state takes place, is very low, generally of the order of a few degrees K, and the attainment of the superconducting state requires the use of liquid helium as a coolant. Whilst the metals and alloys which possess the property of superconductivity potentially have very many applications, for example, in electrical power transmission lines which in use result in little or no loss of power, in electric motors, in magnetic levitation applications such as in transportation systems which operate on the magnetic levitation principle, in scientific instruments, eg in superconducitng quantum interference devices (SQUIDS), and in structures for use in magnetic screening, eg in the screening of electrical equipment, the application of such materials has been severely limited because of the very low transition temperatures (Tc) at which the superconducting state is achieved. The need for such very low temperatures requires the use of liquid helium as a coolant and the expense of liquid helium has limited the practical application of the phenomenon of superconductivity to uses in scientific instruments, such as in nuclear magnetic research scanners.

Materials having a low transition temperature to the superconducting state will hereafter be referred to as LTC materials, or LTC superconductors.

In a more recent development the phenomenon of superconductivity has been observed in certain materials at substantially higher temperatures than those at which superconductivity has been observed hitherto in LTC materials and which are attainable only by cooling with liquid helium. In particular, the phenomenon of superconductivity has been observed in certain materials at temperatures as high as 77K, or even higher, that is at temperatures which are attainable by cooling with liquid nitrogen. The fact that superconductivity is attainable at such relatively high temperatures, and the fact that the required coolant is the relatively inexpensive liquid nitrogen, has opened up the possibility of much more widespread practical applications of the phenomenon of superconductivity than have been possible hitherto.

In Z. Phys. B. - Condensed Matter, 64, pp 189-193 (1986) J G Bednorz and K A Muller reported the preparation of coprecipitated and heat treated mixtures of lanthanum, barium, copper and oxygen and they reported that the mixtures showed superconductivity at a critical temperature higher than the critical temperatures which had been observed hitherto for LTC materials. The mixtures were reported to have the composition $La_{5-x}Ba_xCu_5O_{5(3-y)}$ where $x = 0.75$ to 1 and $Y > 0$ and the compositions were prepared by coprecipitation from barium, lanthanum and copper nitrate solutions by addition to an oxalic acid solution followed by decomposition and solid state reaction at $900^\circ C$ for 5 hours and sintering in an oxygen atmosphere.

In published European Patent Application 0 275 343 there is described a superconducting material having a critical temperature above 28K, and which may be as high at 35K. The compound is of the $RE_2TMO_4$ type wherein a rare earth element (RE) is partially substituted by one or more alkaline earth metal elements (AE) and wherein the oxygen content is adjusted such that the resulting crystal structure is distorted and comprises a phase of the general compositions $RE_{2-x}AE_xTMO_{4-y}$, wherein TM represents a transition metal and $x < 0.3$ and $y < 0.5$. A favoured rare earth element is lanthanum, a favoured alkaline earth element is barium, and a favoured transition metal is copper.

In International Patent Application No PCT/US 87/02958, International Publication No WO 88/05029, there is described a material which is superconducting at a temperature of 40K and higher, and which comprises a sintered metal oxide complex of the formula $[L_{1-x}M_x]_aA_bO_y$ in which L is yttrium, lanthanum, cerium, preasodymium, neodymium, samarium, europium, gadolinium, terbium, dysprosium, holmium, erbium, thulium, ytterbium, or lutetium, or a combination thereof, M is barium, strontium, calcium, magnesium, mercury, or a combination thereof, provided that when L is lanthanum M is not barium, A is copper, bismuth, tungsten, zirconium, tantalum, niobium, or vanadium, x is from about 0.01 to 1.0, a is 1 to 2, b is 1, and y is about 2 to 4.

In the aforementioned International Publication there is also described the production of the sintered metal oxide complex by heating a mixture of solid compounds containing L, M, A and O in proportions appropriate to yield the aforementioned formula to a temperature of 640-800°C in an oxygen atmosphere and for a time sufficient to react the mixture in the solid state and then heating the mixture at 900-1100°C for a period of at least about 12 hours subsequent to the reaction, pelletizing the mixture, and sintering the pellets. With certain of the sintered metal oxide complexes a critical temperature as high as 100K has been observed. A preferred sintered metal oxide complex is that in which L is yttrium, M is barium and A is copper and one phase of such a preferred material which has been identified as having a high critical temperature is that having the empirical formula $YBa_2Cu_3O_x$ where x is typically between 6.5 and 7.2, generally about 7.

The materials which exhibit superconductivity at such relatively high temperatures are ceramic oxide materials which are relatively easy to make and are relatively inexpensive, and they will be referred to hereafter as HTC materials, or HTC superconductors.

The mechanisms by which LTC and HTC materials conduct superconducting electrical currents are believed to be quite different. Thus, the mechanism by which LTC materials are believed to conduct superconducting currents is by the movement of electron pairs, the so-called Cooper pairs, whereas the mechanism by which the newly discovered HTC materials are believed to conduct superconducting currents is believed to be associated with defects in the structures of the HTC materials, that is the absence of electrons in the structure. Thus, it is believed that the mechanisms by which LTC and HTC materials conduct superconducting currents are completely different, and in view of this difference it would be expected that where an LTC material and an HTC material are in contact a superconducting current would not pass from one material to the other, even when the materials are at a temperature below the transition temperature of the LTC material.

The present invention is based on the surprising observations that in a composite conductor comprising an LTC material in contact with an HTC material there is quantum coherence of the respective macroscopic superconducting wave functions in the LTC and HTC materials, that superconducting electrical currents persist in the composite conductor, and that there is quantisation of magnetic flux in the composite conductor in units of h/2e, where h is Planck's constant and e is the charge on the electron.

These surprising observations have opened up the possibility of constructing a hybrid device in which the benefits of both LTC and HTC materials may be realised, and according to the present invention there is provided a device which comprises a superconductor having a critical temperature of 20K or below in contact with a superconductor having a critical temperature of 77K or above. In a separate embodiment the invention also provides a device which comprises a metal or alloy superconductor having a low critical temperature in contact with a ceramic oxide superconductor having a high critical temperature.

The metal or alloy superconductor will be of the LTC type, and will generally be a metal or alloy which is superconducting at a critical temperature of 20K or below and which requires the use of liquid helium in order to achieve a temperature at which the superconducting state is achieved. The ceramic oxide superconductor will be of the HTC type and it is preferably a ceramic oxide superconductor which is superconducting and which thus has a critical temperature of 77K or above and which requires only the use of liquid nitrogen in order to achieve a temperature at which the superconducting state is achieved.

The invention will be described hereafter with reference to superconductors of the aforementioned metal or alloy type and the ceramic oxide type.

The observations on which the present invention is based have opened up the possibility of producing devices as described in which in using the device liquid helium may be used to cool that part of the device comprising a metal or alloy superconductor whereas the much less expensive liquid nitrogen may be used to cool that part of the device comprising a ceramic oxide superconductor. An additional benefit provided by the device of the invention is that where the device is used in the detection of changes in magnetic flux, as in a SQUID, the detection part of the device may comprise the metal or alloy superconductor and be cooled in liquid helium in order that the influence of background noise magnetic flux may be much reduced, the effect of background noise being much lower at liquid helium temperature than at liquid nitrogen temperature and being particularly severe at low frequency. The remainder of the superconducting part of the device may comprise for example a ceramic oxide superconductor and be cooled in liquid nitrogen.

The metal or alloy superconductor and the ceramic oxide superconductor of the device of the invention may have any suitable form, but they may be in the form of a loop.

The device of the invention may be used to detect changes in magnetic flux and it may be a SQUID. The SQUID may be an RF SQUID including microwave bias, a DC SQUID or an R SQUID which may be used for absolute temperature measurement. Another application of the device of the invention is in microwave detection and mixing.

The metal or alloy superconductor part of the device of the invention may be any metal or alloy which is superconducting at or near low temperatures and which are achievable by cooling with liquid helium. There are very many such metals or alloys known to the art, and merely by way of example there will be mentioned niobium metal, and niobium-tin and niobium-titanium alloys.

Many examples of ceramic oxide superconducting materials have already been mentioned. These materials may form the ceramic oxide superconducting part of the device of the invention, although for reasons which have already been explained, it is preferred that the latter superconductor has a transition temperature which is not lower than 77K.

Preferred ceramic oxide superconductors comprise a superconductor having a formula as hereinbefore referred to with respect to International Publication No WO 88/05029, and indeed in the aforementioned formula when L is lanthanum M may be barium.

A superconductor which is preferred as it has a particularly high critical temperature is an yttrium-barium-copper oxide superconductor, for example, the material having the composition $YBa_2Cu_3O_x$ where x is between 6.5 and 7.2 generally about 7, as this material has a high critical temperature, which may be above the boiling point of liquid nitrogen, that is above 77K. A bismuth-calcium-copper oxide superconductor also has a high critical temperature. Another superconductor of the ceramic oxide type which may be mentioned is that comprising lanthanum-barium-copper oxide, although the invention is not limited to use with any specific superconductor of the ceramic oxide type, and many such superconductors may be used in the production of the device of the invention. Other examples of suitable superconductors are described in the published literature, eg in Australian patent application 88 14255, and in published European patent applications 287749 and 287810. Another example is Japanese Patent Publication 63230564 which discloses a superconductor $(A_{1-x}B_x)_yCuO_2$ where x = 0.01-0.3, y = 1.3-2.2, z = 2.0-4.0, A = Ga, Zr, Nb or Ge and B = Ba or Sr.

The ceramic oxide superconductor may be produced in particulate form by forming a mixture of the oxides of the desired elements in the required proportions, and/or a mixture of decomposible precursors of the oxides of the desired elements, eg a mixture of carbonates and/or nitrates, heating the mixture at an elevated temperature in an oxygen-containing atmosphere, eg at a temperature of 900 to 950°C or higher in oxygen, for a time which is of the order of 12 to 24 hours, and subsequently cooling the thus formed ceramic oxide material, preferably in an oxygen atmosphere, and grinding the material to convert it into the desired particulate form.

The ceramic oxide superconductor part of the device of the invention may be produced by a process in which a composition comprising a particulate ceramic oxide superconducting material, or a particulate mixture of precursors of the material, and for example a solid organic material in a liquid diluent, or a solution of such an organic material, is mixed and shaped, the shaped composition is then heated to remove the organic material and liquid diluent if present, and the shaped composition is further heated, if necessary to convert the precursors into the ceramic oxide superconducting material, and to sinter the particles of ceramic oxide superconducting material.

In the device of the invention the metal or alloy superconductor is in contact with the ceramic oxide superconductor. There should be a good firm contact between the respective superconductors, as, for example by making the contact under an applied pressure, or by contacting a ceramic oxide superconductor with a molten or heat softened metallic or alloy superconductor, or by screwing one such superconductor into a cavity in the other such superconductor, or by pressing a suitably shaped piece of one superconductor into a space or cavity in the other superconductor.

The invention is now illustrated by specific embodiments thereof.

A particulate mixture of $BaCO_3$, $CuO$, and $Y_2O_3$ in proportions by weight of 52.9: 32.0: 15.1 was charged to a plastic container together with ethanol and the mixture was mixed and ground on a vibro energy mill using zirconia as a grinding medium. The mixture was removed from the plastic container and dried on a rotary evaporator and then heated in a furnace in an atmosphere of air at a temperature of 900°C for 12 hours. The mixture was then removed from the furnace and reground using the above-described procedure until the resulting particulate material had a surface area as measured by the BET method in the range 1 to 6 $m^2g^{-1}$. The particulate material had a particle size in the range 0.001 to 5 microns and had a composition, as determined by X-ray diffraction, of $YBa_2Cu_3O_x$.

100 parts by weight of the particulate material were mixed with 7 parts by weight of polyvinyl butyral and with 10.5 parts by weight of cyclohexanone, and the viscous composition was passed repeatedly through the nip between the rolls of a twin-roll mill at ambient temperature. The composition which adhered to one of the rolls of the mill was repeatedly removed from the roll, turned at right angles, and passed back through the nip in order to produce a homogeneously mixed composition. During the mixing procedure on the twin-roll mill some of the cyclohexanone evaporated.

The sheet which was produced on the mill was removed from the mill and chopped into small pieces and charged to a mould and compressed into the form of a disc. The disc was then removed from the mould and heated in an oven to evaporate the cyclohexanone, then heated at $450^{\circ}$C for 60 minutes to burn off the polyvinyl butyral, and finally the disc was heated in an atmosphere of oxygen at $920^{\circ}$C for 10 hours to decompose the $BaCO_3$ to the oxide and to form the ceramic oxide superconducting material, and the oven and contents were cooled to $400^{\circ}$C in an atmosphere of oxygen at a rate of $1^{\circ}$C per minute. The temperature of the oven was then held at $400^{\circ}$C for 15 hours and finally it was cooled to ambient temperature at a rate of $1^{\circ}$C $min^{-1}$. The value of x in $YBa_2Cu_3O_x$ was 7.0 as determined by thermogravimetric analysis. The disc had a diameter of 13 mm and a thickness of 3 mm. The $YBa_2Cu_3O_7$ material of the disc served as an HTC superconductor in the device of the invention.

Two holes of diameter 2.5 mm and 2.1 mm were drilled through the disc, a 0.5 mm slot was machined between the holes, and another slot was machined from the first slot to the outer perimeter of the disc. A $60^{\circ}$ niobium tip as an LTC superconductor was screwed down into the slot at a position close to the perimeter of the disc to form a continuous superconducting circuit including the two holes. The strength of the two "bridging-contacts" formed between the sloping sides of the niobium tip LTC superconductor and the upper edges of the slot in the HTC superconductor could easily be adjusted from room temperature. A toroidal coil was passed through one hole to provide a known amount of external flux within the completed superconducting loop. The second hole contained the primary coil of a dc superconducting flux transformer with the secondary weakly coupled to a conventional rf SQUID to monitor changes in flux within the superconducting loop. Electrical leads were attached to the niobium LTC superconductor and to the ceramic oxide HTC superconductor so that the current/voltage (I/V) characteristics across the LTC-HTC contacts could be measured.

The niobium point was screwed down to bridge the slot in the disc at liquid helium temperatures and all measurements were made at 4.2K. The superconducting contacts were remarkably stable on thermally cycling wihtin the liquid helium temperature range and could easily be adjusted to the desired strengths.

Before the contacts were made, there was almost no magnetic coupling between the toroidal coil and the flux transformer. However, on closing the superconducting loop, the flux measured by the detecting circuit was directly proportional to the flux applied by the toroidal coil. This follows from the conservation of total flux within a superconducting circuit. Such measurements provided a direct calibration of the flux sensitivity of the SQUID detection system in terms of a precisely known flux within the completed superconducting loop. On increasing the applied flux, the induced supercurrent eventually exceeded the critical current of the weakest junction in the circuit and flux could move in or out of the ring. The induced supercurrents showed no indication of decay on the time scale of a measurement (typically 20 minutes), immediately implying a phase coherence around a fully superconducting circuit or a contact resistance at the interface of $R \ll 10^{-13}$ $\Omega$.

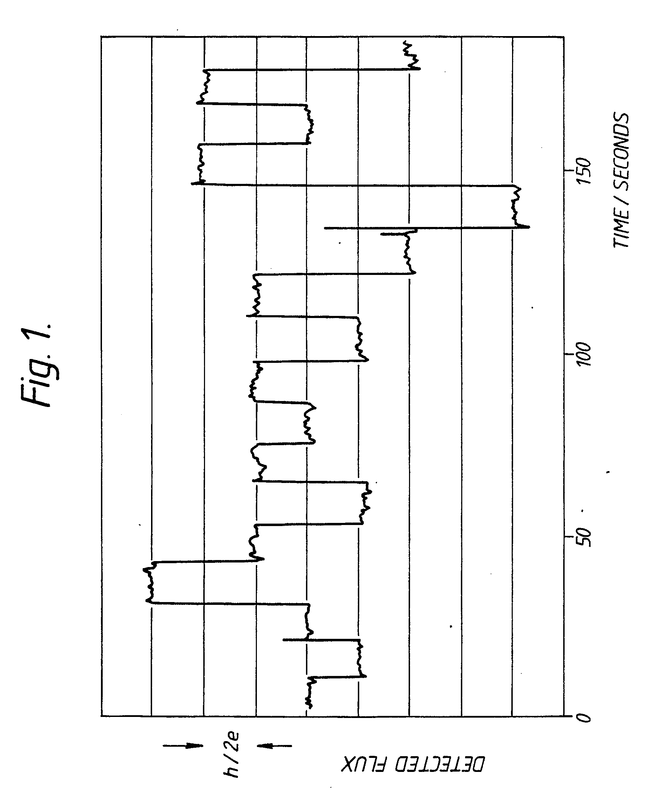

As a definitive test of macroscopic quantum coherence, the existence of excited quantum states of the ring was demonstrated by causing transitions between such states by periodically exposing the ring to short bursts of 5MHz electromagnetic radiation. These transitions correspond to discrete changes of flux within the ring, which are multiples of the flux quantum, as illustrated in Figure 1. The horizontal lines in Figure 1 are the expected separation of flux states assuming flux quantisation in units of h/2e. The observation of flux in multiples of h/2e proves that the superconducting wave functions of the HTC and LTC superconductors are coupled at their interface allowing a coherent superconducting wave function to persist around the composite HTC-LTC superconductor device.

As another demonstration of quantum coherence a modified experimental geometry was used which enabled a DC SQUID to be devised.

In this case the device comprised a 13 mm thick 3 mm diameter HTC superconductor disc as hereinbefore described having two holes of 2.5 mm and 2.1 mm drilled through the disc and a slot connecting the holes. In this device a $60^{\circ}$ niobium tip as an LTC superconductor was positioned in the slot which bridged the two holes.

In such a device the phases of the wave function across the two HTC-LTC interfaces are functions of the flux passing through the superconducting loops, which gives rise to interference effects very similar to double slit diffraction in optics.

The niobium LTC superconductor which bridged the slot connecting the two holes resulted in two superconducting loops around the holes in the HTC superconductor with a common section comprising the niobium link plus the two HTC-LTC interfaces.

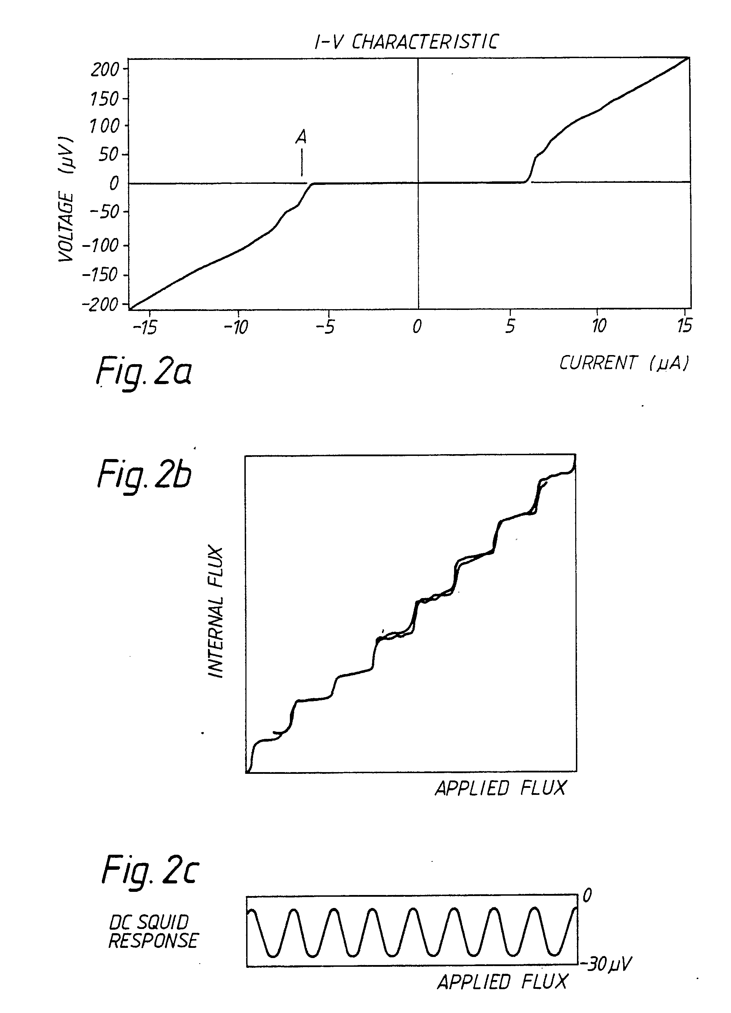

An electrical current was passed from the LTC superconductor to the HTC superconductor and the voltage across the device was recorded in a standard four-terminal configuration. Figure 2a shows a typical set of I/V characteristics. These characteristics are reversible indicating that the weak-link junctions are heavily damped with the structure above the critical current.

In this geometry also quantum coherence around the HTC-LTC superconducting circuit was demonstrated by monitoring the flux in one hole as the flux in the second hole was varied. In the absence of the LTC niobium bridging contact, the flux in the second hole was directly proportional to the externally applied flux, as expected. However, on bridging the connecting slot with the LTC niobium point, the flux developed a periodic component with period equal to the flux quantum, as demonstrated by Figure 2b.

Quantum interference was demonstrated by observing that the critical current determined from the I/V characteristics exhibited periodicity with applied flux. Measurements were obtained by adjusting the current to just above the critical current, point A on Figure 2a, and observing the change in voltage as the applied flux was varied, as illustrated in Figure 2c.

All the measurements shown in Figures 2a-c are for the same setting of the LTC niobium point.

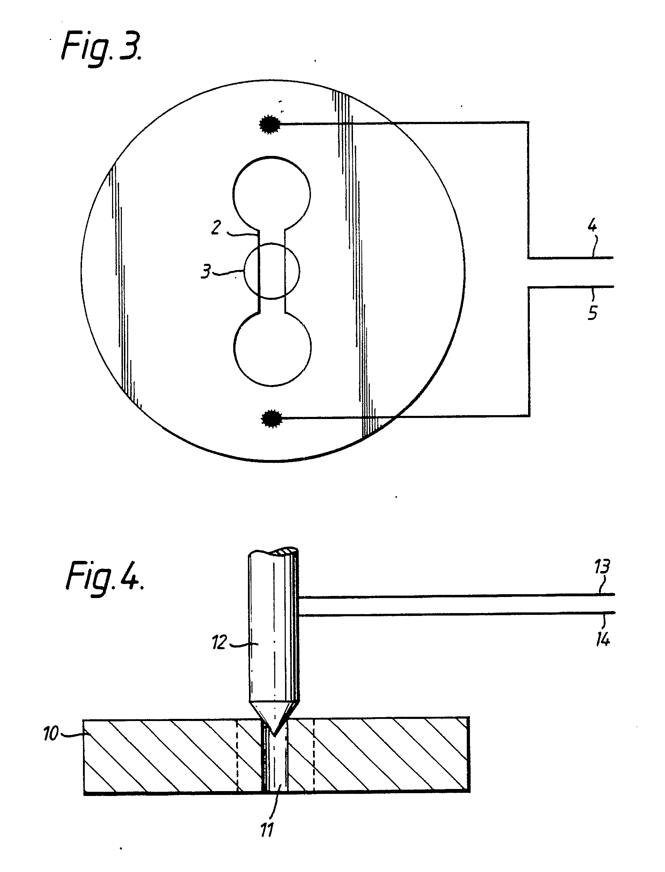

In figures 3 to 5 there are shown diagrammatic representations of three separate examples of devices of the invention in the form of SQUIDS.

Referring to Figure 3 1 is an HTC ceramic oxide superconductor in the form of a disc having a slot 2 which is bridged by a niobium LTC superconductor 3 in contact with the ceramic oxide superconductor. 4 and 5 represent the current and voltage leads.

Referring to Figure 4 10 is an HTC ceramic oxide superconductor in the form of a disc having a slot 11 which is bridged by a niobium LTC superconductor 12 in contact with the ceramic oxide superconductor. 13 and 14 represent the current and voltage leads.

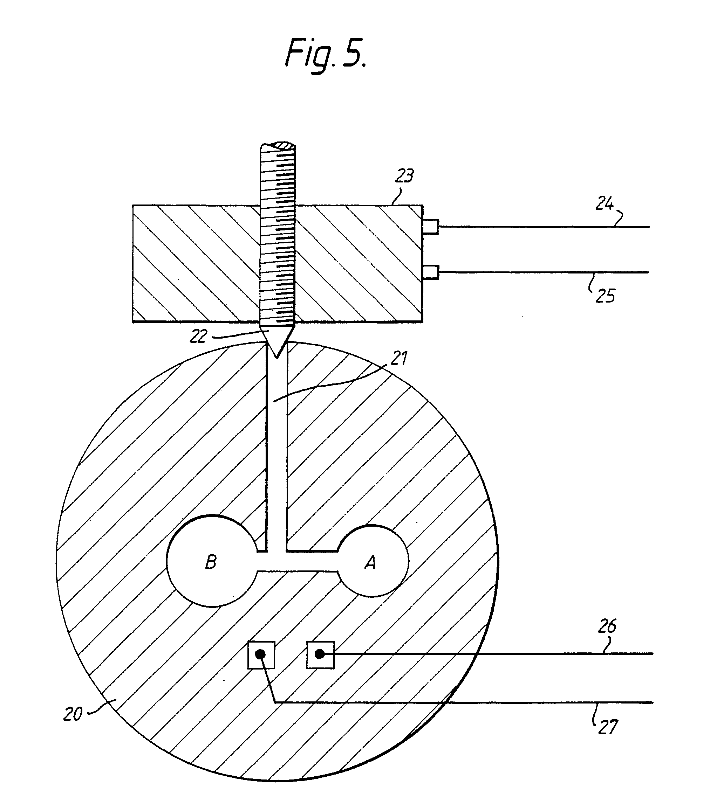

Referring to Figure 5 20 is an HTC ceramic oxide superconductor in the form of a disc and having a slot 21 of the shape different form the slot of the device of Figures 3 and 4. The slot 21 is bridged by a niobium LTC superconductor screw 22 set in a brass block 23, and 24, 25 and 26, 27 represent the current and voltage leads.

## Claims

1. A device which comprises a superconductor having a critical temperature of 20K or below in contact with a superconductor having a critical temperature of 77K or above.

2. A device which comprises a metal or alloy superconductor having a low critical temperature in contact with a ceramic oxide superconductor having a high critical temperature.

3. A device as claimed in claim 2 in which the metal or alloy superconductor has a critical temperature of 20k or below.

4. A device as claimed in claim 2 or claim 3 in which the ceramic oxide superconductor has a critical temperature of 77K or above.

5. A device as claimed in any one of claims 1 to 4 in which the superconductor having a high critical temperature is an yttrium-barium-copper oxide superconductor.

6. A device as claimed in claim 5 in which the superconductor has a composition $YBa_2Cu_3O_x$ where x is in the range 6.5 to 7.2.

7. A device as claimed in any one of claims 1 to 4 in which the superconductor having a high critical temperature is a bismuth-calcium-copper oxide superconductor.

8. A device as claimed in any one of claims 1 to 7 in which the device is a SQUID.

9 A device as claimed in claim 8 in which the SQUID is an RF SQUID or a DC SQUID.

10. A device as claimed in any one of claims 1 to 9 in which the device is in the form of a loop.

Fig. 1.

EP 0 404 405 A2

I-V CHARACTERISTIC

Fig. 2a

Fig. 2b

Fig. 2c

Fig. 3.

2
3

4
5

Fig. 4.

13

12

14

10

11

# Fig. 5.